(19) Europäisches Patentamt / European Patent Office / Office européen des brevets

(11) **EP 4 427 056 B1**

(12) **FASCICULE DE BREVET EUROPEEN**

(45) Date de publication et mention
de la délivrance du brevet:
**23.07.2025 Bulletin 2025/30**

(21) Numéro de dépôt: **22789942.4**

(22) Date de dépôt: **24.10.2022**

(51) Classification Internationale des Brevets (IPC):
**G01R 27/02** *(2006.01)* **G01R 31/52** *(2020.01)*
**G01R 31/36** *(2020.01)*

(52) Classification Coopérative des Brevets (CPC):
**G01R 31/52; G01R 27/025; G01R 31/36**

(86) Numéro de dépôt international:
**PCT/EP2022/079582**

(87) Numéro de publication internationale:
**WO 2023/078714 (11.05.2023 Gazette 2023/19)**

(54) **PROCÉDÉ DE DÉTECTION DES DÉFAUTS D'ISOLEMENT D'UN VÉHICULE AUTOMOBILE**

VERFAHREN ZUR ERKENNUNG VON ISOLATIONSFEHLERN IN EINEM KRAFTFAHRZEUG

METHOD FOR THE DETECTION OF INSULATION FAULTS IN A MOTOR VEHICLE

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **04.11.2021 FR 2111726**

(43) Date de publication de la demande:
**11.09.2024 Bulletin 2024/37**

(73) Titulaire: **Ampere SAS
92100 Boulogne-Billancourt (FR)**

(72) Inventeur: **HALALCHI, Houssem
78084 Guyancourt (FR)**

(74) Mandataire: **Renault Group
Renault s.a.s.
1 avenue du Golf
FR TCR AVA 055
78084 Guyancourt Cedex (FR)**

(56) Documents cités:
**EP-B1- 2 890 990 EP-B1- 3 385 729**

**Description**

L'invention concerne un procédé de détection des défauts d'isolement d'un véhicule automobile.

Dans le domaine de la gestion des batteries d'accumulateurs électriques des véhicules automobiles, il est particulièrement important de détecter un potentiel défaut d'isolement dans les meilleurs délais.

En particulier, dans les véhicules automobiles électriques ou hybrides les batteries sont composées d'une succession de blocs de cellules mis en série les uns à la suite des autres.

Ainsi, afin de permettre une maintenance rapide de la batterie il est relativement important de détecter le défaut d'isolement le plus rapidement possible et de déterminer à quel bloc de la batterie le défaut est présent.

On connaît à cet effet des méthodes et des dispositifs de détection de défauts d'isolement basés sur la mesure de la résistance d'isolement de la batterie.

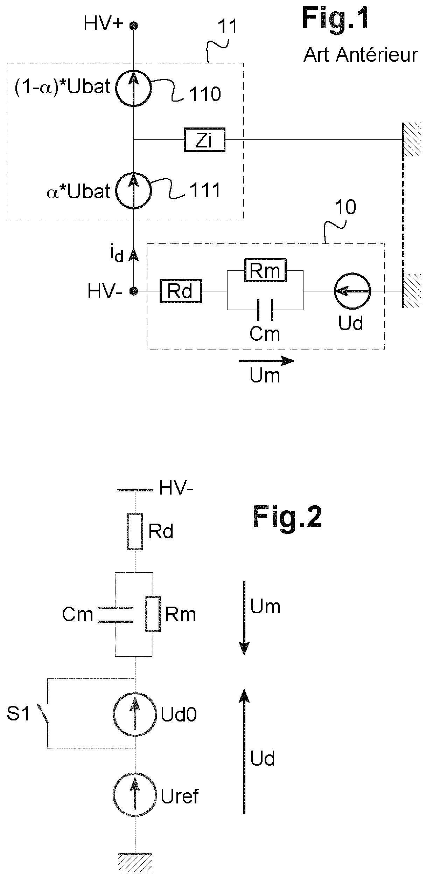

Tel que représenté en figure 1 de l'art antérieur, une batterie 11 est représentée sous la forme d'une source de tension 110, 111 et d'une impédance d'isolement Zi.

Un dispositif de mesure 10 de la résistance d'isolement Ri comprend une résistance de limitation de courant Rd, une résistance de filtrage Rm, une capacité de filtrage Cm et une source de tension Ud.

Ce dispositif de mesure 10 monté entre la borne inférieure de la batterie 11 et la masse permet de déterminer si la batterie présente un défaut d'isolement et en quel emplacement, en fonction d'une valeur $\alpha$ calculée comme exposé ci-après.

En effet, il est possible de déterminer une valeur $\alpha$ permettant de déterminer la position du défaut dans la succession de blocs de cellules mis en série les uns à la suite des autres.

Tout d'abord, on applique une première tension $Ud_1$ au circuit et on mesure la tension $Um_1$ aux bornes de la résistance Rm.

Ensuite, on applique une deuxième tension $Ud_2$, d'une valeur différente de la première et on mesure la tension $Um_2$ aux bornes de la résistance Rm.

Ensuite on procède au calcul de la résistance d'isolement Ri et de la position $\alpha$ du défaut dans la batterie.

L'effet capacitif étant négligeable, et en considérant la tension totale de la batterie Ubat constante sur les deux essais, on obtient en régime permanent :

$$R_i = R_m \cdot \frac{U_{d2} - U_{d1}}{U_{m2} - U_{m1}} - (R_d + R_m) \qquad (1)$$

$$\propto = \frac{U_{m1} U_{d2} - U_{d1} U_{m2}}{U_{bat} \cdot (U_{m2} - U_{m1})} \qquad (2)$$

Si l'on souhaite tenir compte des variations de tension de la batterie de traction Ubat entre les deux mesures, avec $Ubat_1$ lors de la première mesure et $Ubat_2$ lors de la seconde mesure, ces équations deviennent :

$$R_i = \frac{R_m}{U_{m2} - U_{m1}} \cdot \left[ U_{d2} - U_{d1} + \frac{(U_{bat2} - U_{bat1}) \cdot (U_{m1} \cdot U_{d2} - U_{m2} \cdot U_{d1})}{(U_{m2} \cdot U_{bat1} - U_{m1} \cdot U_{bat2})} \right] - (R_d + R_m) \quad (3)$$

$$\propto = \frac{U_{m1} U_{d2} - U_{d1} U_{m2}}{U_{m2} \cdot U_{bat1} - U_{m1} \cdot U_{bat2}} \qquad (4)$$

La mesure de Um étant généralement bruitée, les équations (1)-(2) ou (3)-(4) ne sont pas directement utilisées.

Elles sont généralement adaptées par deux filtres RLS, de l'anglais *Recurvise Least Square,* en français le principe des moindres carrés récursifs, adaptés pour fournir une estimation stable de chacune des deux grandeurs.

Ces filtres utilisent, de manière itérative, les mesures successives de la tension Um dans leur processus de convergence vers les valeurs finales de Ri et $\alpha$.

Ainsi, ce dispositif de mesure fournit périodiquement au superviseur une indication de l'état d'isolement électrique du système de traction et lui permet de prendre les dispositions nécessaires si un défaut d'isolement est constaté.

Toutefois, une telle mise en œuvre de la détection des défauts d'isolement n'est pas optimisée quant à sa durée de convergence vers les valeurs finales de Ri et $\alpha$.

Le document EP3385729B1 décrit une méthode analytique pour le calcul de la durée optimale de commutation du circuit d'alimentation. Toutefois, une telle méthode analytique manque sans doute de fiabilité compte-tenu des variations de paramètres inhérentes à ce type de système.

A cet effet la présente invention propose un procédé de détection d'un défaut d'isolement d'une batterie d'accumulateurs électriques, le procédé étant adapté pour acquérir d'un dispositif de détection une valeur de résistance d'isolement,

> le dispositif de détection étant monté d'une part à une borne de la batterie d'accumulateurs électriques et d'autre part à la masse ; et comprenant en série une résistance de limitation de courant, une résistance de filtrage et une source de tension ainsi qu'un condensateur de filtrage en parallèle de ladite résistance de filtrage,
> ladite source de tension comprenant une source permanente et une autre source, activable par un interrupteur monté en parallèle à ses bornes ;
> le procédé détectant le défaut d'isolement en fonction d'une valeur de résistance d'isolement obtenue en fonction des mesures de la résistance de limitation de courant, de la résistance de filtrage et du condensateur de filtrage ; ces mesures étant obtenues pour deux valeurs distinctes de la source de tension acquises selon un écart de temps défini par une période de commutation de l'interrupteur.

Le procédé met en œuvre un ensemble d'étapes d'optimisation de la période de commutation comprend :

- Une étape d'initialisation de la période de commutation de l'interrupteur et d'un compteur de temps ; et en boucle, par pas successifs espacés d'une durée prédéterminée, les étapes suivantes :

  o Mesure de la tension aux bornes de la résistance de filtrage ;
  o Le calcul de la variation de la tension mesurée entre le pas courant et un pas précédent ;
  o Si ladite variation calculée est supérieure à une valeur de seuil prédéterminée, on procède à l'incrémentation du compteur de temps de la durée prédéterminée ; et
  o Si ladite variation calculée est inférieure à ladite valeur de seuil prédéterminée, ladite période de commutation est alors définie comme étant égale à la valeur du compteur de temps.

Ainsi on peut optimiser le temps de détection d'un défaut d'isolement de batterie lors de la mise en œuvre d'un dispositif de détection de défaut d'isolement.

Avantageusement et de manière non limitative, lorsque la variation est inférieure à ladite valeur de seuil prédéterminée, on ajoute en outre à ladite période de commutation une marge temporelle de sécurité. Ainsi, on peut s'assurer que la durée de convergence ne soit pas plus rapide qu'une potentielle durée de stabilisation qui varierait légèrement entre deux commutations de l'interrupteur du dispositif de mesure.

Avantageusement et de manière non limitative, l'ensemble d'étapes d'optimisation de la période de commutation est mis en œuvre à la mise sous tension de la batterie d'accumulateurs électriques. Ainsi, on peut détecter de manière fiable, rapide et permanente un défaut d'isolement de la batterie.

Avantageusement et de manière non limitative, l'ensemble d'étapes d'optimisation de la période de commutation est mis en œuvre lorsqu'une étape préalable de détection d'un défaut potentiel détecte la possibilité d'un défaut d'isolement. Ainsi, on peut confirmer rapidement une suspicion de détection de défaut d'isolement de la batterie.

En particulier ladite étape préalable de détection d'un défaut potentiel en fonction de l'estimation d'une valeur de résistance d'isolement acquise d'un dispositif de gestion de la batterie sur un bus de données bidirectionnel, tel qu'un bus CAN, et en fonction d'un seuil de tension prédéfini. Ceci permet d'obtenir un déclenchement pertinent d'une suspicion de détection de défaut d'isolement.

L'invention concerne aussi un dispositif de détection d'un défaut d'isolement d'une batterie d'accumulateurs électriques,

> monté d'une part à une borne de la batterie d'accumulateurs électriques et d'autre part à la masse ; et comprenant en série une résistance de limitation de courant, une résistance de filtrage et une source de tension ainsi qu'un condensateur de filtrage en parallèle de ladite résistance de filtrage,
> ladite source de tension comprenant une source permanente et une autre source, activable par un interrupteur monté en parallèle à ses bornes ;
> ledit dispositif étant adapté pour mesurer une valeur de résistance d'isolement ;
> le dispositif étant adapté pour détecter le défaut d'isolement en fonction d'un valeur de résistance d'isolement obtenue en fonction des mesures de la résistance de limitation de courant, de la résistance de filtrage et du condensateur de filtrage ; ces mesures étant obtenues pour deux valeurs distinctes de la source de tension acquises selon un écart de temps défini par une période de commutation de l'interrupteur ; caractérisé en ce que le dispositif comprend des moyens de mise en œuvre d'un ensemble d'étapes d'optimisation de la période de commutation comprenant :

- Une étape d'initialisation de la période de commutation de l'interrupteur et d'un compteur de temps ; et en boucle, par pas successif successifs espacés d'une durée prédéterminée, les étapes suivantes :

    o Mesure de la tension aux bornes de la résistance de filtrage ;
    o Le calcul de la variation de la tension mesurée entre le pas courant et un pas précédent ;
    o Si ladite variation calculée est supérieure à une valeur de seuil prédéterminée, on procède à l'incrémentation du compteur de temps de la durée prédéterminée ; et
    o Si ladite variation calculée est inférieure à ladite valeur de seuil prédéterminée, ladite période de commutation est alors définie comme étant égale à la valeur du compteur de temps.

L'invention concerne aussi un véhicule automobile comprenant un dispositif de détection d'un défaut d'isolement d'une batterie d'accumulateurs électriques tel que décrit précédemment.

D'autres particularités et avantages de l'invention ressortiront à la lecture de la description faite ci-après d'un mode de réalisation particulier de l'invention, donné à titre indicatif mais non limitatif, en référence aux dessins annexés sur lesquels :

[Fig. 1] est une vue schématique d'une batterie d'accumulateurs électriques et d'un dispositif de détection de défaut d'isolement connu de l'art antérieur ;
[Fig. 2] est une vue schématique du dispositif de détection d'un défaut d'isolement de la batterie ;

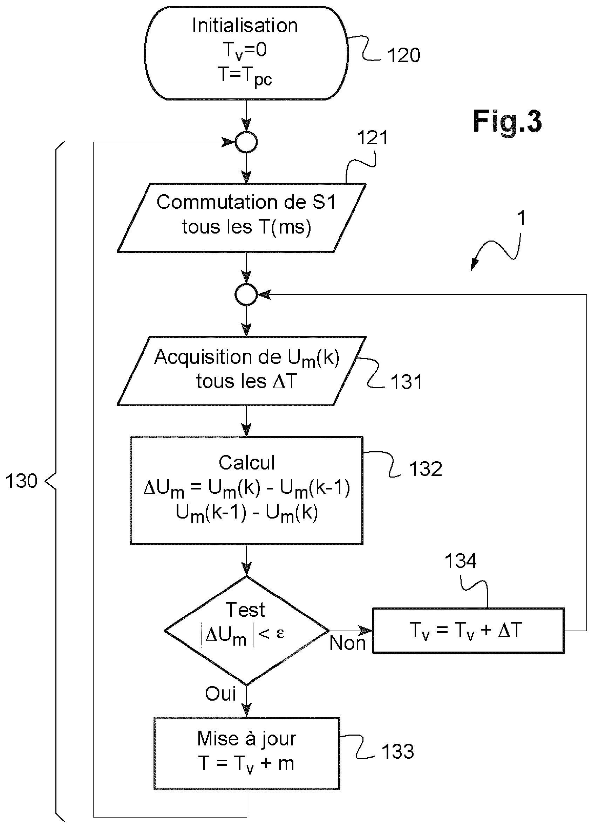

[Fig. 3] est un organigramme d'un procédé selon un premier mode de réalisation de l'invention ;
[Fig. 4] est un schéma représentant la tension Um mesurée par le disposition de détection d'isolement dans un réglage dit « pire-cas » de la commutation de l'interrupteur S1 connu de l'art antérieur ;
[Fig. 5] est un schéma représentant la convergence temporelle de l'estimation de la résistance d'isolement $R_i$ dans le cadre d'une approche des moindre carrés récursifs, en anglais *Recurvise Least Square,* dans un réglage dit « pire-cas » de la commutation de l'interrupteur S1 connu de l'art antérieur;
[Fig. 6] est un schéma représentant la tension Um mesurée par le disposition de détection d'isolement dans un réglage optimisé par le procédé selon l'invention ;
[Fig. 7] est un schéma représentant la convergence temporelle de l'estimation de la résistance d'isolement $R_i$ dans le cadre d'une approche des moindre carrés récursifs, en anglais *Recurvise Least Square,* dans un réglage optimisé par le procédé selon l'invention ; et
[Fig. 8] est un schéma représentation la relation linéaire entre la tension mesurée dans un bus de données CAN (*Controller Area Network*) en fonction de l'estimation de résistance d'isolement $R_i$.

Le procédé 1 de détection d'un défaut d'isolement d'une batterie d'accumulateurs électriques selon l'invention se base sur un dispositif de détection décrit précédemment pour l'art antérieur.

En effet, le procédé 1 selon l'invention présente l'avantage de ne pas nécessiter de modification structurelle du dispositif de détection 10 de la résistance d'isolement Ri qui comprend une résistance de limitation de courant Rd, une résistance de filtrage Rm, une capacité de filtrage Cm et une source de tension Ud.

La commande de ce dispositif 10 est représenté en figure 2.

Il est nécessaire pour mettre en œuvre la détection d'un défaut d'isolement, de générer deux tensions différentes $U_{d1}$ et $U_{d2}$.

Les deux états stables de la source de tension Ud schématisés dans les figures 1 et 2 ont pour expressions :

$$U_{d1} = U_{d0} + U_{ref} \quad (5)$$

$$U_{d2} = U_{ref} \quad\quad (6)$$

L'interrupteur S1 est commuté 121 périodiquement par le dispositif de gestion de la batterie pour prendre en compte ou non de la tension d'alimentation $U_{d0}$, et par voie de conséquence, l'obtention des valeurs $U_{d1}$ et $U_{d2}$, utilisées dans les équations (1) et (2) ou (3) et (4).

La durée T de chacun des états, défini par l'application de l'une ou de l'autres des valeurs de $U_d$, doit être suffisant pour permettre une stabilisation complète du circuit de mesure et l'atteinte de la valeur finale de la tension mesurée $U_{m1}$ et $U_{m2}$.

Du fait du caractère récursif des filtres RLS utilisés, de l'anglais *Recurvise Least Square,* cette durée joue un rôle primordial dans l'obtention de la durée totale de détection de défaut d'isolement $T_d$, obéissant à la formule :

$$T_d = 2\,N_d\,T \qquad (7)$$

Où $N_d$ est le nombre d'itérations nécessaires à la convergence du filtre RLS vers le seuil de détection de défaut. Le facteur 2 est dû à la nécessité d'attendre une période complète de commutation (ouverture/fermeture) de S1 pour obtenir les mesures $U_{m1}$ et $U_{m2}$ à la fin de chaque état.

La durée T d'un état de l'interrupteur S1 peut être réglée de diverses manières. La seule condition primordiale, pour avoir une mesure en régime stabilisé est :

$$T > 5\,\tau_i + m \qquad (8)$$

où :

$\tau_i$ = RiCi : est la constante de temps associée à l'impédance d'isolement.
m : est une marge appliquée pour tenir compte des effets de filtrage analogique et numérique appliqués à la mesure.

Le réglage le plus simple de la durée T, connu de l'art antérieur, consiste à prendre une durée constante qui constitue une constante de temps $\tau_i$ que l'on peut qualifier de pire-cas, c'est-à-dire des valeurs maximales de Ri et Ci permettant la détection d'un défaut d'isolement :

$$T_{pc} = 5\,\tau_{i\,max} + m \qquad (9)$$

Ce réglage pire-cas est très robuste, puisqu'il couvre la totalité des cas de défaillance que l'on souhaite détecter. Toutefois, cette robustesse est obtenue au prix d'une dégradation de la performance, en particulier le temps de détection de défaut régi par l'équation (7).

Au lieu du pire cas, l'invention met en œuvre un procédé permettant d'ajuster la durée T à la dynamique réelle du circuit électrique en détectant l'atteinte du régime permanent de ce dernier.

Ainsi, afin de réduire la durée de convergence du procédé vers une estimation fiable de l'existence d'un défaut d'isolement, on met en œuvre des étapes permettant d'optimiser la période de commutation de l'interrupteur commandé S1.

En effet, afin de calculer la résistance d'isolement Ri et la position alpha il est nécessaire de commuter l'interrupteur S1 une pluralité de fois selon une période T calculée.

Afin d'optimiser cette période de commutation, le procédé 1 met en œuvre un ensemble d'étapes d'optimisation de la période de commutation T comprenant tout d'abord une étape d'initialisation 120 de la période de commutation T de l'interrupteur S1.

Cette période de commutation peut par exemple être initialisée à une valeur de 2 secondes.

On met aussi en route un compteur de temps Tv.

Le procédé 1 met ensuite en œuvre, sous forme de boucle 130, à intervalle régulier, espacés d'une durée prédéterminée $\Delta_T$, par exemple ici initialisée à 100ms.

On réalise à chaque itération de la boucle :

Une mesure 131 de la tension $U_m$ aux bornes de la resistance de filtrage $R_m$.

Puis on calcule 132 la variation de la tension mesurée aux bornes de la résistance $R_m$ entre l'itération précédente de la boucle (donc à t- $\Delta_T$) et la mesure de l'tération courante.

On obtient ainsi une valeur de variation $\Delta U_m$ de la résistance Rm sur une durée de $\Delta_T$.

Si cette variation est supérieure à une valeur de seuil prédéterminée, alors on incrémente 134 le compteur de temps Tv de la durée prédéterminée $\Delta_T$.

Si cette variation est inférieure ou égale à cette valeur de seuil, on considère que la valeur de la résistance de fuite a convergé vers une valeur stable. On définit 133 alors la période de commutation T comme étant égale à la valeur du compteur de temps Tv.

Puis on recommence la boucle 130 pour l'itération suivante, en s'assurant que le temps entre deux itérations $\Delta_T$ soit atteint.

Ainsi, comme en parallèle les commutations de l'interrupteur S1 continuent selon cet intervalle de temps T, c'est la nouvelle valeur de cet intervalle de temps qui sera prise en compte, permettant une convergence optimisée pour la mise en œuvre du procédé de détection de la défaillance et de la position de la défaillance de la batterie d'accumulateur électrique.

Ce procédé a été mis en œuvre de manière expérimentale, par simulation du système de détection de défauts d'isolement avec les valeurs de paramètres suivantes :

$$R_d = 2.1 \text{ M}\Omega, \; R_m = 17 \text{ k}\Omega, \; U_{d0} = 58.48 \text{ V}, \; U_{ref} = 4.096 \text{ V}.$$

Dans cette mise en œuvre de l'invention, l'effet capacitif Cm n'est pas directement appliqué tel que représenté dans le schéma de la figure 2, mais sous la forme d'un double filtre RC présentant une fréquence de coupure de 200 Hz.

Le procédé de détection est paramétré de la manière suivante :
$\varepsilon$ = 10 mV est le seuil de détection de stabilisation de la mesure et m = 300 ms, qui est une marge tenant compte du filtrage et du traitement numérique.

Un défaut d'isolement à la limite de l'exigence de détection de défauts est appliqué à la batterie : Ri = 199.9 kOhm et Ci = 1.5 $\mu$F est provoqué à l'instant initial t = 0.

Le réglage pire-cas de la durée de commutation est défini pour l'initialisation de la valeur de commutation : T = Tpc = 2000 ms.

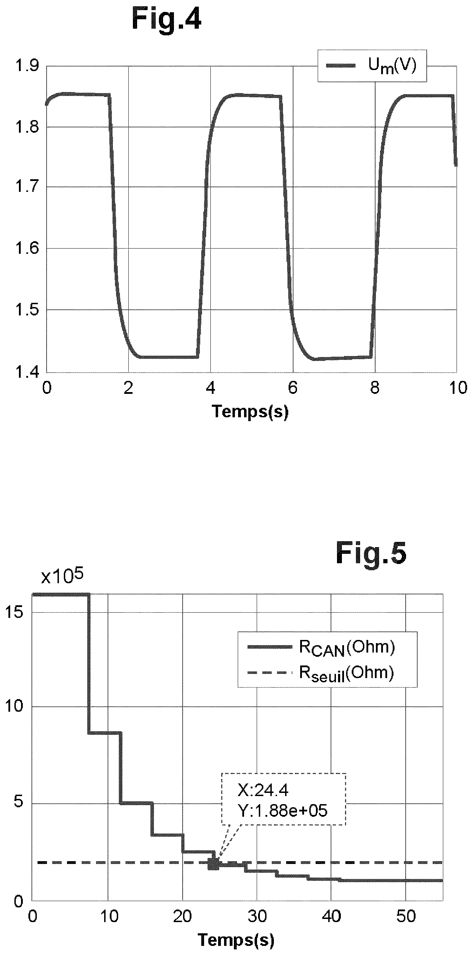

Les couples de figures 4-5 et 6-7 montrent respectivement les résultats de détection obtenus avec un réglage pire-cas constant de la durée de commutation et un réglage optimisé de cette durée.

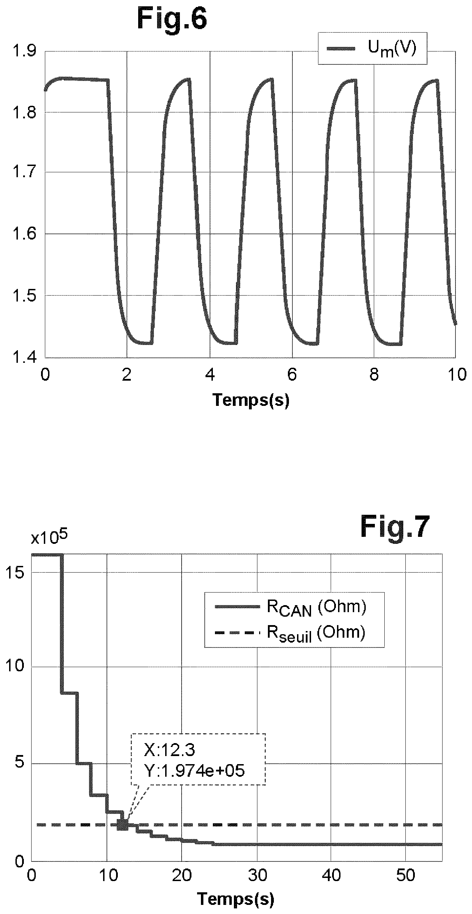

La Figure 7 illustre la tension mesurée avec un réglage optimisé, il est ainsi possible de remarquer que la première commutation complète s'arrête lorsque la stabilisation est détectée, avec des une durée de Tv = 600 ms.

En ajoutant la marge de sécurité m = 300 ms, on obtient un temps de commutation de T = Tv + m = 900 ms appliqué pour les commutations suivantes.

La Figure 7, représente le gain en temps de détection de défaut obtenu grâce au réglage optimisé. Ainsi, ce temps de détection Td passe de 24,4 secondes (dans le cas non optimisé représenté figure 5, à 12,3 secondes, soit une réduction de sensiblement 50%.

Ce gain s'explique par l'équation (7) qui présente une relation de proportionnalité entre le temps de commutation de l'interrupteur T et le temps de détection de défaut Td, avec un nombre d'itérations Nd = 6 pour la convergence de l'algorithme RLS.

Le procédé 1 selon l'invention peut être activé selon deux critères principaux, qui se rapportent à deux modes de fonctionnement principaux de l'invention :

- Mode de détection de défaut d'isolement qui est mis en œuvre lorsque le procédé est actif dès le début de la mission véhicule. Ici, l'objectif est de détecter un défaut potentiel, sans assurer une mesure précise de résistance d'isolement.
- Mode de mesure de résistance d'isolement, mis en œuvre lorsque le procédé est déclenché sur détection d'événement, la durée de l'état de l'interrupteur gardant sa valeur maximale en dehors de cet événement. Ceci permet d'obtenir une estimation relativement précise pour les valeurs hautes de résistance d'isolement, et de favoriser la rapidité de détection en déclenchant l'algorithme d'optimisation de durée lorsqu'un défaut est détecté.

En d'autres termes, dans ce deuxième mode on ne déclenche le procédé d'optimisation 1 que lors qu'il existe une suspicion de défaut d'isolement.

Aux fins de détection de cet événement, le superviseur du véhicule électrique, connu sous l'abréviation HEVC, détecte le défaut d'isolement suspecté, aussi appelé événement, en comparant l'estimation de résistance d'isolement $R_{CAN}$ que lui envoie le dispositif de gestion de la batterie, dit BMS, sur le bus de données bidirectionnel dit bus CAN, avec un seuil prédéfini $R_{seuil}$.

On peut obtenir en première approximation :

$$R_{CAN} = R_i / R_d \, (10)$$

Le système estime alors qu'un défaut d'isolement est détecté si :

$$R_{CAN} < R_{seuil} \; (11)$$

En combinant la contrainte de l'inégalité (11) avec l'expression de $R_i$ de l'équation (1), nous pouvons déduire un nouveau critère basé directement sur la variation de la mesure sur une période complète de commutation de l'interrupteur : $\Delta U_m^{(période)} = U_{m2} - U_{m1}$.

$$\Delta U_m^{(période)} > \frac{\Delta U_d R_m}{\frac{R_{seuil} R_d}{R_d - R_{seuil}} + R_d + R_m} = E \qquad (12)$$

où $\Delta U_d = U_{d2} - U_{d1} = U_{d0}$ est la variation de la tension d'alimentation sur une période.

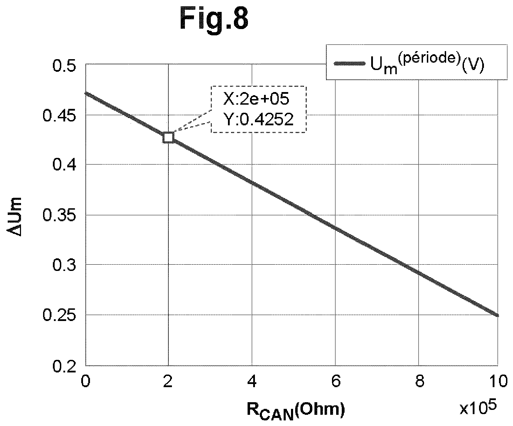

Le changement de sens de l'inégalité entre les contraintes (11) et (12) est dû à la proportionnalité inverse entre $\Delta U_m^{(période)}$ et $R_{CAN}$ illustrée en Figure 8, où sont placées les valeurs de $R_{seuil}$ = 200 kOhm et la valeur limite correspondante de E = 0.4252 V.

C'est uniquement lorsque l'inégalité (12) est vérifiée que l'on active le procédé (1).

En d'autres termes, au lieu d'activer le procédé d'optimisation de durée de commutation de l'interrupteur dès le début de la mission véhicule, il est possible de le déclencher en cas d'anomalie constatée dans la tension électrique mesurée.

Par exemple, un écart important entre les deux points de fonctionnement $\Delta U_m^{(période)} = U_{m2} - U_{m1}$ indique une résistance d'isolement faible, donc la présence potentielle d'un défaut d'isolement qu'il faudrait pouvoir détecter le plus vite possible. La valeur de cet écart peut également servir de critère de relâchement de l'algorithme d'optimisation de durée lorsque le retour à la normale est détecté, par exemple si $\Delta U_m^{(période)} \ll E$.

Afin de mettre le procédé 1 selon l'invention en parallèle de la commande de commutation de l'interrupteur S par le module de gestion de la batterie, le procédé peut être mis en œuvre sur un cœur de processeur, un calculateur séparé ou encore un fil d'exécution (en anglais *thread*) indépendant du même processeur que celui mis en œuvre par le module de gestion de la batterie fréquemment abrégé BMS de l'anglais *Battery Management System*.

**Revendications**

1. Procédé (1) de détection d'un défaut d'isolement d'une batterie d'accumulateurs électriques, le procédé étant adapté pour acquérir d'un dispositif de détection une valeur de résistance d'isolement ($R_i$),

   le dispositif de détection étant monté d'une part à une borne de la batterie d'accumulateurs électriques et d'autre part à la masse ; et comprenant en série une résistance de limitation de courant ($R_d$), une résistance de filtrage (Rm) et une source de tension ($U_d$) ainsi qu'un condensateur de filtrage (Cm) en parallèle de ladite résistance de filtrage ($R_m$),
   ladite source de tension ($U_d$) comprenant une source permanente ($U_{ref}$) et une autre source ($U_{d0}$), activable par un interrupteur ($S_1$) monté en parallèle à ses bornes ;
   le procédé détectant le défaut d'isolement en fonction d'une valeur de résistance d'isolement ($R_i$) obtenue en fonction des mesures de la résistance de limitation de courant ($R_d$), de la résistance de filtrage ($R_m$) et du condensateur de filtrage ($C_m$); ces mesures étant obtenues pour deux valeurs distinctes de la source de tension ($U_d$) réalisées de manière périodique par une étape de commutation (121) de l'interrupteur ($S_1$) ; **caractérisé en ce que** le procédé (1) met en œuvre un ensemble d'étapes d'optimisation de la période de commutation (T) comprenant :

   - Une étape d'initialisation (120) de la période de commutation (T) de l'interrupteur ($S_1$) et d'un compteur de temps ($T_v$); et en boucle (130), par pas successifs (t-1, t, t+1) espacés d'une durée prédéterminée ($\Delta_T$), les étapes suivantes :

       o Mesure (131) de la tension aux bornes de la résistance de filtrage ($R_m$);
       o Le calcul (132) de la variation de la tension mesurée entre le pas courant (t) et un pas précédent (t-1) ;
       o Si ladite variation calculée est supérieure à une valeur de seuil prédéterminée, on procède à l'incrémentation (134) du compteur de temps ($T_v$) de la durée prédéterminée ($\Delta_T$) ; et
       o Si ladite variation calculée est inférieure à ladite valeur de seuil prédéterminée, ladite période de commutation (T) est alors définie (133) comme étant égale à la valeur du compteur de temps ($T_v$).

2. Procédé selon la revendication 1 **caractérisé en ce que** lorsque la variation est inférieure à ladite valeur de seuil prédéterminée, on ajoute en outre à ladite période de commutation (T) une marge temporelle de sécurité (m).

3. Procédé selon l'une quelconque des revendications 1 ou 2, **caractérisé en ce que** l'ensemble d'étapes d'optimisation de la période de commutation (T) est mis en œuvre à la mise sous tension de la batterie d'accumulateurs électriques.

4.  Procédé selon l'une quelconque des revendications 1 ou 2, **caractérisé en ce que** l'ensemble d'étapes d'optimisation de la période de commutation (T) est mis en œuvre lorsqu'une étape préalable de détection d'un défaut potentiel détecte la possibilité d'un défaut d'isolement.

5.  Procédé selon la revendication 4, **caractérisé en ce que** ladite étape préalable de détection d'un défaut potentiel en fonction de l'estimation d'une valeur de résistance d'isolement ($R_{CAN}$) acquise d'un dispositif de gestion de la batterie sur un bus de données bidirectionnel, tel qu'un bus CAN, et en fonction d'un seuil de tension prédéfini ($R_{seuil}$).

6.  Dispositif de détection d'un défaut d'isolement d'une batterie d'accumulateurs électriques, ledit dispositif étant adapté pour être monté d'une part à une borne de la batterie d'accumulateurs électriques et

    d'autre part à la masse ; et comprenant en série une résistance de limitation de courant ($R_d$), une résistance de filtrage ($R_m$) et une source de tension ($U_d$) ainsi qu'un condensateur de filtrage ($C_m$) en parallèle de ladite résistance de filtrage ($R_m$),
    ladite source de tension ($U_d$) comprenant une source permanente ($U_{ref}$) et une autre source ($U_{d0}$), activable par un interrupteur monté en parallèle à ses bornes ;
    ledit dispositif étant adapté pour mesurer une valeur de résistance d'isolement ($R_i$),
    Le dispositif étant adapté pour détecter le défaut d'isolement en fonction d'un valeur de résistance d'isolement ($R_i$) obtenue en fonction des mesures de la résistance de limitation de courant ($R_d$), de la résistance de filtrage ($R_m$) et du condensateur de filtrage ($C_m$); ces mesures étant obtenues pour deux valeurs distinctes de la source de tension ($U_d$) acquises selon un écart de temps défini par une période de commutation (T) de l'interrupteur ($S_1$) ;
    **caractérisé en ce que** le dispositif comprend des moyens de mise en œuvre d'un ensemble d'étapes d'optimisation de la période de commutation (T) comprenant :

    -   Une étape d'initialisation de la période de commutation (T) de l'interrupteur et d'un compteur de temps ($T_v$); et en boucle, par pas successifs (t-1, t, t+1) espacés d'une durée prédéterminée ($\Delta_T$), les étapes suivantes :

        o Mesure de la tension aux bornes de la résistance de filtrage ($R_m$);
        o Le calcul de la variation de la tension mesurée entre le pas courant (t) et un pas précédent (t-1) ;
        o Si ladite variation calculée est supérieure à une valeur de seuil prédéterminée, on procède à l'incrémentation du compteur de temps ($T_v$) de la durée prédéterminée ($\Delta_T$) ; et
        o Si ladite variation calculée est inférieure à ladite valeur de seuil prédéterminée, ladite période de commutation (T) est alors définie comme étant égale à la valeur du compteur de temps ($T_v$).

7.  Véhicule automobile comprenant un dispositif de détection d'un défaut d'isolement d'une batterie d'accumulateurs électriques selon la revendication 6.

**Patentansprüche**

1.  Verfahren (1) zur Erkennung eines Isolationsfehlers einer Akkumulatorenbatterie, wobei das Verfahren geeignet ist, einen Isolationswiderstandwert (R,) von einer Erkennungsvorrichtung zu erlangen,

    wobei die Erkennungsvorrichtung einerseits an einen Pol der Akkumulatorenbatterie und andererseits an Masse montiert ist ; und in Reihe einen Strombegrenzungswiderstand (Ra), einen Filterwiderstand (Rm) und eine Spannungsquelle (Ua) sowie einen Filterkondensator (Cm) parallel zum Filterwiderstand (Rm) enthält,
    wobei die Spannungsquelle (Ua) eine permanente Quelle (Ur) und eine andere Quelle (Uao) enthält, die von einem Schalter aktiviert werden kann, der parallel zu ihren Polen montiert ist;
    wobei das Verfahren den Isolationsfehler abhängig von einem Isolationswiderstandswert (Ri) erkennt, der abhängig von den Messungen des Strombegrenzungswiderstands (Ra), des Filterwiderstands (Rn) und des Filterkondensators (C) erhalten wird; wobei diese Messungen für zwei unterschiedliche Werte der Spannungsquelle (Ua) realisiert werden, die periodisch durch einen Schaltschritt (121) des Schalters durchgeführt werden ;
    **dadurch gekennzeichnet, dass** das Verfahren (1) einen Satz von Optimierungsschritten der Schaltperiode (T) anwendet, der enthält:

    -   einen Initialisierungsschritt (120) der Schaltperiode (T) des Schalters (Si) und eines Zeitzählers (T); und in Schleife (130), in aufeinanderfolgenden Schritten (t-1, t, t+ 1), die um eine vorbestimmte Dauer beabstandet sind (Ar), die folgenden Schritte :

◦ Messung (131) der Spannung an den Polen des Filterwiderstands (Rn);
◦ Berechnung (132) der Änderung der Spannung gemessen zwischen dem aktuellen Schritt (t) und einem vorhergehenden Schritt (t-1);
◦ wenn die berechnete Änderung größer ist als ein vorbestimmter Schwellwert, wird die Inkrementierung (134) des Zeitzählers (T) um die vorbestimmte Dauer (r) durchgeführt ; und
◦ wenn die berechnete Änderung kleiner ist als der vorbestimmte Schwellwert, wird die Schaltperiode (T) als gleich dem Wert des Zeitzählers (T) definiert (133).

2. Verfahren nach Anspruch 1, **dadurch gekennzeichnet, dass**, wenn die Änderung kleiner ist als der vorbestimmte Schwellwert, der Schaltperiode (T) außerdem eine Sicherheitszeitmarge (m) hinzugefügt wird.

3. Verfahren nach einem der Ansprüche 1 oder 2, **dadurch gekennzeichnet, dass** der Satz von Optimierungsschritten der Schaltperiode (T) beim Hochfahren der Akkumulatorenbatterie angewendet wird.

4. Verfahren nach einem der Ansprüche 1 oder 2, **dadurch gekennzeichnet, dass** der Satz von Optimierungsschritten der Schaltperiode (T) angewendet wird, wenn ein vorhergehender Schritt der Erkennung eines potentiellen Fehlers die Möglichkeit eines Isolationsfehlers erkennt.

5. Verfahren nach Anspruch 4, **dadurch gekennzeichnet, dass** der vorhergehende Schritt der Erkennung eines möglichen Fehlers abhängig von der Schätzung eines Isolationswiderstandswerts (RcAN), erlangt von einer Verwaltungsvorrichtung der Batterie auf einem bidirektionalen Datenbus, wie einem CAN-Bus, und von einer vordefinierten Spannungsschwelle (R).

6. Vorrichtung zur Erkennung eines Isolationsfehlers einer Akkumulatorenbatterie, wobei die Vorrichtung geeignet ist, einerseits an einen Pol der Akkumulatorenbatterie und andererseits an Masse montiert zu werden; und in Reihe einen Strombegrenzungswiderstand (Ra), einen Filterwiderstand (Rm) und eine Spannungsquelle (Ua) sowie einen Filterkondensator (Cm) parallel zum Filterwiderstand (Rn) enthält,

wobei die Spannungsquelle (Ua) eine permanente Quelle (U) und eine andere Quelle (Uao) enthält, die von einem Schalter (Si) aktiviert werden kann, der parallel zu ihren Polen montiert ist;
wobei die Vorrichtung geeignet ist, einen Isolationswiderstandswert (R) zu messen,
wobei die Vorrichtung geeignet ist, den Isolationsfehler abhängig von einem Isolationswiderstandswert (Ri) zu erkennen, der abhängig von den Messungen des Strombegrenzungswiderstands (Ra), des Filterwiderstands (Rn) und des Filterkondensators (C) erhalten wird; wobei diese Messungen für zwei unterschiedliche Werte der Spannungsquelle (Ua) erhalten werden, die gemäß einem Zeitabstand definiert durch eine Schaltperiode (T) des Schalters (Si) erlangt werden ; **dadurch gekennzeichnet, dass** die Vorrichtung Einrichtungen zur Anwendung eines Satzes von Optimierungsschritten der Schaltperiode (T) enthält, der enthält :

- einen Initialisierungsschritt der Schaltperiode (T) des Schalters (Si) und eines Zeitzählers (T); und in Schleife, in aufeinanderfolgenden Schritten (t-1, t, t+ 1), die um eine vorbestimmte Dauer (Ar) beabstandet sind, die folgenden Schritte :

◦ Messung der Spannung an den Polen des Filterwiderstands (Rm);
◦ Berechnung der Änderung der gemessenen Spannung zwischen dem aktuellen Schritt (t) und einem vorhergehenden Schritt (t-1);
◦ wenn die berechnete Änderung größer ist als ein vorbestimmter Schwellwert, wird die Inkrementierung des Zeitzählers (T) um die vorbestimmte Dauer (A) durchgeführt; und
◦ wenn die berechnete Änderung kleiner ist als der vorbestimmte Schwellwert, wird die Schaltperiode (T) als gleich dem Wert des Zeitzählers (T) definiert.

7. Kraftfahrzeug, das eine Vorrichtung zur Erkennung eines Isolationsfehlers einer Akkumulatorenbatterie nach Anspruch 6 enthält.

**Claims**

1.  Method (1) for detecting an insulation fault in an electrical accumulator battery, the method being designed to acquire an insulation resistance value ($R_i$) from a detection device,

    the detection device being connected, on the one hand, to an electrical accumulator battery terminal and, on the other hand, to ground; and comprising, in series, a current-limiting resistor ($R_d$), a filtering resistor (Rm) and a voltage source ($U_d$), and a filtering capacitor (Cm) in parallel with said filtering resistor ($R_m$),
    said voltage source ($U_d$) comprising a permanent source ($U_{ref}$) and another source ($U_{d0}$) that is able to be activated by a switch that is connected in parallel with the terminals thereof;
    the method detecting the insulation fault as a function of an insulation resistance value ($R_i$) obtained as a function of the measurements from the current-limiting resistor ($R_d$), the filtering resistor ($R_m$) and the filtering capacitor ($C_m$); these measurements being obtained for two separate values of the voltage source ($U_d$) performed periodically by a switching step (121) of the switch ($S_1$); **characterized in that** the method (1) implements a set of steps for optimizing the switching period (T), comprising:

    - a step of initializing (120) the switching period (T) of the switch and a time counter ($T_v$); and in a loop (130), in successive increments (t-1, t, t+1) spaced apart by a predetermined duration ($\Delta_T$), the following steps of:

        o measuring (131) the voltage across the terminals of the filtering resistor ($R_m$);
        o calculating (132) the variation of the voltage measured between the current increment (t) and a preceding increment (t-1);
        o if said calculated variation is greater than a predetermined threshold value, the time counter ($T_v$) is incremented (134) by the predetermined duration ($\Delta_T$); and
        o if said calculated variation is lower than said predetermined threshold value, said switching period (T) is then defined (133) as being equal to the value of the time counter ($T_v$).

2.  Method according to Claim 1, **characterized in that**, when the variation is lower than said predetermined threshold value, a safety time margin (m) is also added to said switching period (T).

3.  Method according to either of Claims 1 and 2, **characterized in that** the set of steps for optimizing the switching period (T) is implemented when the electrical accumulator battery is turned on.

4.  Method according to either of Claims 1 and 2, **characterized in that** the set of steps for optimizing the switching period (T) is implemented when a preliminary step of detecting a potential fault detects the possibility of an insulation fault.

5.  Method according to Claim 4, **characterized in that** said preliminary step of detecting a potential fault as a function of the estimate of an insulation resistance value ($R_{CAN}$) acquired from a battery management device on a bidirectional data bus, such as a CAN bus, and as a function of a predefined voltage threshold ($R_{threshold}$).

6.  Device for detecting an insulation fault in an electrical accumulator battery, said device being designed to be connected, on the one hand, to an electrical accumulator battery terminal and, on the other hand, to ground; and comprising, in series, a current-limiting resistor ($R_d$), a filtering resistor ($R_m$) and a voltage source ($U_d$), and a filtering capacitor ($C_m$) in parallel with said filtering resistor ($R_m$),

    said voltage source ($U_d$) comprising a permanent source ($U_{ref}$) and another source ($U_{d0}$) that is able to be activated by a switch ($S_1$) that is connected in parallel with the terminals thereof;
    said device being designed to measure an insulation resistance value ($R_i$),
    the device being designed to detect the insulation fault as a function of an insulation resistance value ($R_i$) obtained as a function of the measurements from the current-limiting resistor ($R_d$), the filtering resistor ($R_m$) and the filtering capacitor ($C_m$); these measurements being obtained for two separate values of the voltage source ($U_d$) acquired with a time difference defined by a switching period (T) of the switch ($S_1$); **characterized in that** the device comprises means for implementing a set of steps for optimizing the switching period (T), comprising:

    - a step of initializing the switching period (T) of the switch ($S_1$) and a time counter ($T_v$); and in a loop, in successive increments (t-1, t, t+1) spaced apart by a predetermined duration ($\Delta_T$), the following steps of:

        o measuring the voltage across the terminals of the filtering resistor ($R_m$);

o calculating the variation of the voltage measured between the current increment (t) and a preceding increment (t-1);

o if said calculated variation is greater than a predetermined threshold value, the time counter ($T_v$) is incremented by the predetermined duration ($\Delta_T$); and

o if said calculated variation is lower than said predetermined threshold value, said switching period (T) is then defined as being equal to the value of the time counter ($T_v$).

7. Motor vehicle comprising a device for detecting an insulation fault in an electrical accumulator battery according to Claim 6.

# Fig.1

Art Antérieur

HV+

(1-α)*Ubat  110

Zi

α*Ubat  111

11

$i_d$

HV-

Rd

Rm

Cm

Ud

Um

10

# Fig.2

HV-

Rd

Cm  Rm

Um

S1  Ud0

Ud

Uref

**Fig.3**

# Fig.4

# Fig.5

## Fig.6

## Fig.7

# Fig.8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3385729 B1